# FASCICULE DE BREVET EUROPEEN

(11) **EP 1 660 695 B1**
(45) Date de publication et mention de la délivrance du brevet: **17.12.2008**
(21) Numéro de dépôt: 04787297.3
(22) Date de dépôt: 02.09.2004
(51) Int. Cl.: C23C 14/06, C23C 14/22, C03C 17/34

(54) **PROCEDE DE DEPOT D'UNE COUCHE AMORPHE CONTENANT MAJORITAIREMENT DU FLUOR ET DU CARBONE ET DISPOSITIF CONVENANT A SA MISE EN OEUVRE**
VERFAHREN ZUR ABSCHEIDUNG EINER HAUPTSÄCHLICH AUS FLUOR UND KOHLENSTOFF BESTEHENDEN AMORPHEN SCHICHT UND HIERFÜR GEEIGNETE VORRICHTUNG
METHOD FOR DEPOSITING AN AMORPHOUS LAYER PRIMARILY CONTAINING FLUORINE AND CARBON, AND DEVICE SUITED FOR CARRYING OUT THIS METHOD

(30) Priorité: 04.09.2003 FR 0310472; 25.09.2003 FR 0311238
(43) Date de publication de la demande: 31.05.2006
(73) Titulaire: ESSILOR INTERNATIONAL (Compagnie Générale d'Optique), F-94220 Charenton-le-Pont (FR)
(72) Inventeur: SCHERER, Karin, F-94100 St Maur des Fosses (FR); LACAN, Pascale, F-75011 Paris (FR); BOSMANS, Richard, F-94880 Noiseau (FR)
(74) Mandataire: Kurtz, Laurent Charles Edmond
(86) Numéro de dépôt international: PCT/FR2004/002242
(87) Numéro de publication internationale: WO 2005/024086

(56) Documents cités:
- EP-A- 0 265 365
- EP-A- 0 942 072
- WO-A-00/05742
- WO-A-01/36342
- WO-A-02/065537
- US-A1- 2003 003 702
- US-A1- 2003 148 102

## Description

La présente invention a pour objet un procédé de dépôt sous vide d'une couche amorphe contenant majoritairement du fluor et du carbone, en particulier fluorocarbonée, sur un substrat.

Certains matériaux fluorocarbonés, lorsqu'ils sont utilisés en couches minces sont transparents dans le visible et possèdent un bas indice de réfraction, par exemple le polytétrafluoroéthylène (n=1.35 à 630 nm).

Leur utilisation comme couche bas indice dans un traitement anti-reflet est donc particulièrement appropriée car ils permettent un bas niveau de réflexion et une parfaite transparence dans toute la gamme spectrale du visible. Notamment dans le domaine des antireflets sur verres ophtalmiques, il est intéressant de disposer d'un matériau à indice de réfraction inférieur à celui de la silice (n ∼1.47 à 630 nm), matériau aujourd'hui couramment utilisé, car cela permet d'optimiser l'efficacité des antireflets tout en conservant un nombre de couches restreint.

Cependant, les matériaux fluorocarbonés présentent souvent une mauvaise adhérence sur la plupart des matériaux. Cela est par exemple le cas lorsque l'on dépose par évaporation sous vide un composé fluorocarboné, tel que du Téflon^{®} amorphe. Cette mauvaise adhérence est un frein à leur développement, surtout dans le cas d'articles courants dont l'utilisation est intensive comme les lentilles ophtalmiques, qu'il convient de nettoyer fréquemment.

Un autre procédé utilisé dans l'industrie est le dépôt chimique en phase vapeur assistée par plasma (PECVD: Plasma Enhanced Chemical Vapour Deposition) qui est décrit, par exemple, dans la demande de brevet internationale WO 98/33077. La méthode est basée sur l'utilisation de plasmas pour dissocier des gaz précurseurs et ainsi créer des radicaux résultants libres, aptes à se réassocier pour former un matériau homogène adhérant à la surface des objets introduits dans la chambre de réaction. Cette technique est satisfaisante mais nécessite l'utilisation d'un équipement onéreux.

En outre, la transparence des couches fluorocarbonées obtenues par PECVD est décevante car lesdites couches sont généralement de couleur jaunâtre.

C'est pourquoi une nouvelle stratégie de dépôt est ici proposée, qui consiste à utiliser un canon à ions permettant d'éjecter des ions fluorocarbonés ou hydrofluorocarbonés sous la forme d'un faisceau d'ions accélérés, lequel va bombarder le substrat tout en apportant les électrons nécessaires à la constitution de composés contenant du fluor et du carbone électriquement neutres.

Ce procédé permet d'assurer d'une manière simple et efficace l'adhérence d'une couche fluorocarbonée amorphe à bas indice de réfraction sur un substrat optique ou une couche sous-jacente, de sorte à constituer une couche ou un empilement anti-reflets propre à être utilisé pour la production de lentilles ophtalmiques ayant une très bonne résistance aux chocs et aux rayures, une parfaite transparence et un indice de réfraction très bas.

De plus, ce procédé peut être facilement mis en oeuvre dans une machine d'évaporation classique, ce qui permet l'évaporation des premières couches, suivi directement du dépôt de la couche fluorocarbonée amorphe.

L'invention, dans son ensemble, a ainsi pour objet un procédé de dépôt sous vide d'une couche amorphe contenant majoritairement du fluor et du carbone sur un substrat, au moyen d'un canon à ions propre à éjecter des ions sous forme d'un faisceau d'ions accélérés créé à partir d'au moins un composé contenant du fluor et du carbone sous forme gazeuse ou de vapeur saturante alimentant le canon à ions, caractérisé en ce qu'il comporte l'étape de dépôt de cette couche comme couche extérieure bas indice d'un empilement anti-reflets déposé sur le substrat.

Suivant des dispositions préférées :
- le canon à ions est alimenté par au moins un composé contenant du fluor et du carbone, en mélange avec de l'oxygène, ou au moins un gaz rare ; et/ou
- le canon à ions est alimenté par au moins un composé fluorocarboné aliphatique ou cyclique, au moins un hydrocarbure fluoré aliphatique ou cyclique, ou un mélange de ceux-ci.

La couche fluorocarbonée pouvant être obtenue selon l'invention consiste en un agrégat de composés essentiellement constitués d'atomes de fluor et de carbone. Elle est destinée à recouvrir la surface du substrat ou une couche sous-jacente de manière continue suivant une épaisseur qui varie typiquement entre 1 et 500 nm. Elle possède notamment un bas indice de réfraction et une faible constante diélectrique.

Une telle couche fluorocarbonée est amorphe dans la mesure où les molécules fluorocarbonées qui la composent ne forment généralement pas de polymère ou de structure cristalline de grande dimension.

Pour améliorer l'efficacité du procédé, on utilisera plus préférentiellement le perfluorocyclobutane (c-C₄F₈) ou bien un mélange de ce composé avec au moins un autre composé fluorocarboné, notamment du tetrafluorométhane (CF₄) ou de l'hexafluorométhane (C₂F₆), ou au moins un gaz rare.

Le gaz rare est de préférence de l'argon ou du xénon.

Les ions positifs crées à partir d'un gaz fluorocarboné sont majoritairement CF3+, CF2+, CF+, C+ et F+ dans des proportions qui dépendent en premier lieu du gaz fluorocarboné utilisé, mais également de la présence d'un gaz additif.

Il est d'ailleurs possible selon le procédé de l'invention, d'obtenir une vitesse de dépôt plus élevée par une augmentation de la tension d'anode, ce qui a pour effet de faciliter la dissociation du gaz fluorocarboné et d'augmenter l'énergie des ions.

Le canon à ions qui est généralement utilisé est un canon à ions du genre présentant une anode annulaire, un filament qui sert de cathode et s'étend diamétralement au-dessus de l'anode annulaire et un aimant disposé en dessous de l'anode annulaire, qui peut être ou non permanent. Le distributeur de gaz, qui alimente le canon en gaz, est disposé, de préférence, entre l'anode et l'aimant.

Ainsi, des électrons sont émis par la cathode, lesquels parcourent une trajectoire définie par les lignes du champ magnétique. Ces derniers sont accélérés vers une zone dite de décharge à proximité de l'anode où ils subissent des collisions avec les molécules des composés contenant du fluor et du carbone. Ces collisions produisent l'ionisation et la dissociation des composés contenant du fluor et du carbone. Les ions et électrons forment un gaz conducteur, ou plasma.

Dans un tel contexte, les ions formés sont accélérés dans toutes les directions de l'espace. Ils vont traverser l'axe du canon à plusieurs reprises avant de s'échapper de la zone de décharge en un faisceau d'ions divergent.

Finalement, la charge positive des ions est neutralisée par une partie des électrons issus de la cathode, si bien que, lorsque ces derniers parviennent sur le substrat, le courant électrique du faisceau est quasi nul.

Le mode de dépôt prévu par l'invention permet l'utilisation de différents substrats, lesquels peuvent être en matière minérale ou de façon plus avantageuse, en matière plastique.

Il peut s'agir en particulier d'une résine telle que le CR-39^{®}, commercialisée par PPG Industries, qui peut être dans certains cas recouverte d'un vernis anti-abrasion et commercialisée alors sous le nom d'ORMA SUPRA^{®}.

Le procédé peut être utilisé pour le dépôt d'une unique couche amorphe contenant majoritairement du fluor et du carbone, cependant l'invention prévoit de réaliser des empilements de couches d'indices de réfraction variables, comprenant une couche contenant majoritairement du fluor et du carbone déposée selon le procédé de l'invention, en vue de fabriquer, entre autres, des lentilles ophtalmiques traitées antireflet.

Lors d'une utilisation du procédé de la présente invention dans le cadre d'un empilement anti-reflets, la couche contenant majoritairement du fluor et du carbone est généralement utilisée pour former la couche extérieure bas indice.

L'invention peut ainsi consister à fabriquer un empilement anti-reflets par des étapes successives de dépôt physique en phase gazeuse sous vide (PVD) de trois couches ayant respectivement, depuis l'intérieur de l'empilement vers l'extérieur, un haut indice de réfraction / un bas indice de réfraction / un haut indice de réfraction, l'empilement de ces couches correspondant préférentiellement à un empilement de type ZrO₂/SiO₂/ZrO₂, où ZrO₂ et SiO₂ désignent les matériaux dont sont constitués ces couches; puis à déposer la couche extérieure amorphe contenant majoritairement du fluor et du carbone au moyen du canon à ions..

Traditionnellement, les empilements antireflets sur lentilles ophtalmiques comportent une dernière couche anti-salissure. Le dépôt d'une telle couche n'est pas nécessaire dans le cadre de l'invention, puisque la couche amorphe contenant majoritairement du fluor et du carbone selon l'invention présente déjà cette propriété anti-salissure.

De préférence, chaque étape de dépôt physique en phase gazeuse sous vide évoquée ci-dessus, comprend l'évaporation du matériau à déposer par canon à électrons.

En pratique, chaque étape de dépôt physique en phase gazeuse est effectuée à une pression inférieure ou égale à 10⁻² Pa.

L'invention porte également sur l'utilisation du procédé tel que défini ci-dessus pour améliorer l'adhérence d'une couche extérieure à base indice de réfraction sur la couche sous-jacente d'un empilement anti-reflets.

Les caractéristiques et avantages de l'invention ressortiront par ailleurs de la description qui va suivre et qui fait référence aux dessins schématiques annexés, sur lesquels :
- la figure 1 est une représentation schématique d'un dispositif de mise en oeuvre du procédé suivant l'invention
- la figure 2 est une représentation schématique en coupe d'un canon à ions pouvant être utilisé pour le procédé selon l'invention; et
- la figure 3 représente un empilement anti-reflets, obtenu selon un mode de réalisation préféré de l'invention.

Dans la forme de réalisation représentée, le dispositif 10 de mise en oeuvre du procédé de dépôt sur un substrat 9, se présente sous la forme d'une chambre 8, où on peut faire le vide, et à l'intérieur de laquelle sont disposés un canon à ions 1 du type MarK II (commercialisé par Commonwealth Scientific), comprenant un aimant fixe 6, et dans l'axe du canon un porte substrat 3, situé dans la direction de sortie des ions 14.

Le substrat 9 est porté par un porte-substrat 3 qui, en pratique, fait partie d'un carrousel classique.

Le gaz alimentant le canon à ions en composés contenant du fluor et du carbone est libéré par dessous l'anode annulaire 4 à la faveur d'un distributeur de gaz 2 constitué d'une plaque percée d'orifices. La quantité de gaz est régulée en amont par un moyen d'alimentation 7, relié à un ou plusieurs débitmètres massiques du type MKS.

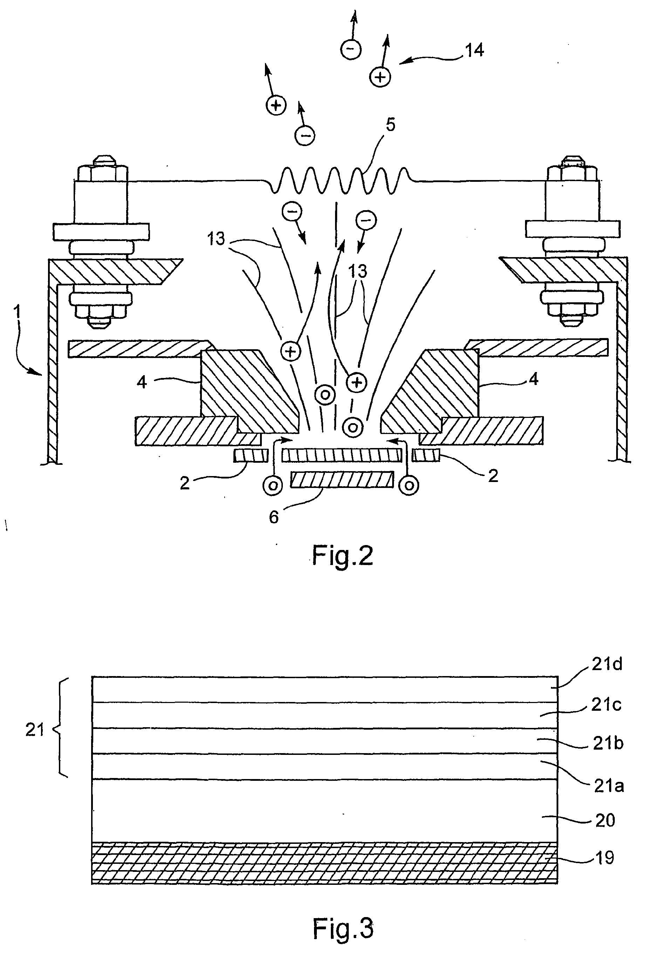

Des électrons sont émis par une cathode 5 et suivent approximativement des lignes du champ magnétique 13 visibles sur la figure 2. Ils sont accélérés vers la zone de décharge à proximité de l'anode 4, et subissent des collisions avec les atomes ou molécules. Une partie de ces collisions produit des ions. Le mélange d'électrons et d'ions dans la région de décharge forme un gaz conducteur, ou plasma. Les ions formés sont accélérés comme indiqué sur la figure 2, et peuvent traverser l'axe du canon à ions plusieurs fois, avant de quitter la source. A la sortie ils forment un faisceau divergent.

Ensuite, la charge d'espace positive de ces ions est neutralisée par une partie des électrons de la cathode 5.

Un système de pompage 11 est prévu pour faire le vide à l'intérieur de la chambre 8 de dépôt, et un piège à froid (piège Meissner), qui n'est pas représenté ici dans un souci de simplification, est disposé à l'intérieur de l'enceinte pour augmenter la vitesse de pompage de l'eau. Il est ainsi possible d'obtenir en quelques minutes, la pression de l'ordre de 10⁻² Pa nécessaire pour le dépôt.

Un canon à électrons 12 du type Leybold ESV6 avec un creuset tournant à quatre cavités est par ailleurs prévu pour l'évaporation par bombardement électronique des matériaux à déposer.

Il convient encore de relever que la cathode 5 se présente sous la forme d'un filament s'étendant diamétralement au-dessus de l'anode annulaire 4.

Un exemple d'un empilement pouvant être obtenu par le procédé suivant l'invention est illustré à la figure 3.

Selon le mode de réalisation illustré sur cette figure, un substrat organique 19 revêtu d'un vernis anti-abrasion 20 disponible dans le commerce sous la dénomination ORMA-SUPRA^{®} est revêtu d'un empilement antireflet comprenant une alternance de couches minces à haut et bas indice de réfraction 21 (a-d).

Selon le mode de réalisation préféré illustré à la figure 2, la première couche 21a est en matériau à haut indice de réfraction, c'est à dire supérieur à 1,6. Ce matériau est ici composé d'oxyde de zirconium (ZrO₂), qui est déposé sur une épaisseur physique comprise typiquement entre 35 et 75 nm.

La seconde couche 21b déposée sur la première couche 21a est ici composée de silice (SiO₂), c'est à dire un matériau à bas indice de réfraction, et d'épaisseur typiquement comprise entre 20 et 40 nm.

La troisième couche 21c déposée ici est identique à la première couche 21a (couche de ZrO₂) sauf pour ce qui concerne l'épaisseur, qui est comprise entre 120 et 190 nm.

Ces trois couches ont été déposées successivement au moyen d'une technique de dépôt physique en phase gazeuse sous-vide (PVD), définie précédemment, grâce au canon à électrons 12.

Notons que d'autres matériaux adaptés et bien connus de l'homme du métier pourraient être utilisés dans la première partie de cet empilement sans en modifier fondamentalement les performances.

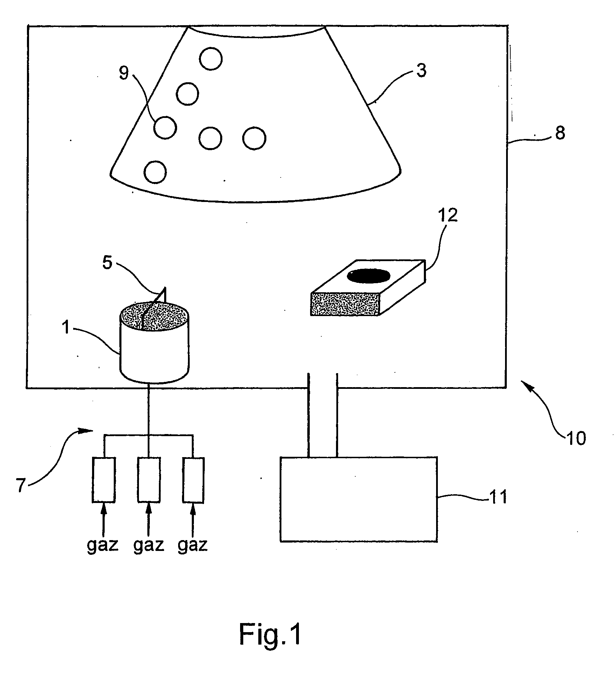

Selon le mode de réalisation préféré, une couche fluorocarbonée amorphe 21d forme une couche extérieure à bas indice de réfraction de l'empilement. Elle est déposée à l'aide d'un canon à ions selon le dispositif de la figure 1. Son épaisseur est comprise entre 70 et 110 nm.

Le dépôt est opéré directement sur la troisième couche 21c à haut indice de réfraction, en plaçant l'échantillon directement au dessus du canon à ions, de préférence de sorte à ce que l'angle formé entre l'axe de l'empilement et celui du canon à ions n'excède pas 30°. Bien entendu, une rotation du caroussel est aussi possible.

Le dépôt s'effectue à l'aide d'une quantité de c-C₄F₈ sous forme gazeuse de 2 sccm (cm³/min en conditions normales), permettant de projeter des ions flurocarbonés.

La tension d'anode étant fixée à environ 100 V, on obtient un courant d'anode compris entre 0.8 et 1 A, ce qui permet une vitesse de dépôt de l'ordre de 3 Angstrôm/s, pour une distance canon-substrat d'environ 30 cm.

Notons qu'il est possible d'optimiser le rendement du dépôt, en introduisant un gaz rare en mélange tel que le xénon, ou bien simplement en augmentant la tension d'anode. Ces manipulations ont pour effet de fractionner davantage les ions qui sont émis par le canon 1.

La couche amorphe déposée a d'abord été inspectée à l'oeil nu : elle est transparente.

On a également constaté un indice de réfraction très bas, de l'ordre de 1,39 à 600 nm pour ce genre de couche.

De plus, on a obtenu un angle de contact pour l'eau supérieur à 90°.

Aucune trace d'abrasion n'a été constatée lors des tests de frottement avec un tissu souple, dans des conditions habituelles de nettoyage de lentilles ophtalmiques.

L'adhésion à la couche sous-jacente est tout à fait satisfaisante et en tout cas meilleure que l'adhésion d'une couche fluorocarbonée obtenue par évaporation sous vide.

Il est donc avéré que le procédé de l'invention permet d'obtenir des empilements anti-reflets ayant des couches minces très denses et présentant des caractéristiques très satisfaisantes du point de vue de l'adhérence et de la résistance aux rayures.

Les empilements obtenus conviennent donc parfaitement pour une utilisation sur des lentilles ophtalmiques.

Bien entendu, la présente invention ne se limite pas à la forme de réalisation décrite et représentée, mais englobe toute variante d'exécution.

## Revendications

1. Procédé de dépôt sous vide d'une couche amorphe contenant majoritairement du fluor et du carbone sur un substrat, au moyen d'un canon à ions propre à éjecter des ions sous forme d'un faisceau d'ions accélérés créé à partir d'au moins un composé contenant du fluor et du carbone sous forme gazeuse ou de vapeur saturante alimentant le canon à ions, **caractérisé en ce qu'**il comporte l'étape de dépôt de cette couche comme couche extérieure bas indice de réfraction d'un empilement anti-reflets déposé sur le substrat.

2. Procédé selon la revendication 1, **caractérisé en ce que** le canon à ions est alimenté par au moins un composé contenant du fluor et du carbone, en mélange avec de l'oxygène, ou au moins un gaz rare.

3. Procédé selon l'une quelconque des revendications 1 et 2, **caractérisé en ce que** le canon à ions est alimenté par au moins un composé fluorocarboné aliphatique ou cyclique, au moins un hydrocarbure fluoré aliphatique ou cyclique, ou un mélange de ceux-ci.

4. Procédé selon la revendication 3, **caractérisé en ce que** le canon à ions est alimenté par du perfluorocyclobutane (c-C₄F₈) ou un mélange de ce composé avec au moins un autre composé fluorocarboné, notamment du tétrafluorométhane (CF₄) ou de l'hexafluorométhane (C₂F₆), ou au moins un gaz rare.

5. Procédé selon l'une quelconque des revendications 1 à 4, **caractérisé en ce que** le substrat est un substrat en matière plastique.

6. Procédé selon l'une quelconque des revendications 2 à 5, **caractérisé en ce qu'**il consiste à fabriquer un empilement anti-reflets par les étapes successives
- de dépôt physique en phase gazeuse (PVD) sous vide de trois couches ayant respectivement, depuis l'intérieur vers l'extérieur, un haut indice de réfraction/ un bas indice de réfraction / un haut indice de réfraction, de préférence du type ZrO₂/SiO₂/ZrO₂;
- de dépôt de la couche extérieure amorphe contenant majoritairement du fluor et du carbone à l'aide du canon à ions.

7. Procédé selon la revendication 6, **caractérisé en ce que** chaque étape de dépôt physique en phase gazeuse sous vide comprend l'évaporation du matériau à déposer par bombardement électronique.

8. Procédé selon la revendication 6 ou 7, **caractérisé en ce que** chaque étape de dépôt est effectuée à une pression inférieure ou égale à 10⁻² Pa.

9. Utilisation du procédé selon l'une quelconque des revendications 1 à 8 pour améliorer l'adhérence d'une couche extérieure à bas indice de réfraction sur la couche sous-jacente d'un empilement anti-reflets.

## Claims

1. Method of depositing an amorphous layer containing mostly fluorine and carbon on a substrate in a vacuum, by means of an ion gun adapted to eject ions in the form of a beam of accelerated ions created from at least one compound containing fluorine and carbon in gas or saturated vapour form fed to the ion gun, **characterised in that** it includes a step of depositing said layer as a low refractive index exterior layer of an antireflection stack deposited on the substrate.

2. Method according to claim 1, **characterised in that** the ion gun is fed with at least one compound containing fluorine and carbon mixed with oxygen or at least one rare gas.

3. Method according to either of claims 1 and 2, **characterised in that** the ion gun is fed with at least one aliphatic or cyclic fluorocarbon compound, at least one aliphatic or cyclic fluorinated hydrocarbon, or a mixture thereof.

4. Method according to claim 3, **characterised in that** the ion gun is fed with perfluorocyclobutane (c-C₄F₈) or a mixture thereof with at least one other fluorocarbon compound, in particular tetrafluoromethane (CF₄) or hexafluoromethane (C₂F₆), or at least one rare gas.

5. Method according to any one of claims 1 to 4, **characterised in that** the substrate is a plastics material substrate.

6. Method according to any one of claims 2 to 5, **characterised in that** it consists in fabricating an antireflection stack by the following steps:
- physical vapour-phase deposition (PVD) in a vacuum of three layers respectively having, from the interior toward the exterior, a high refractive index/a low refractive index/a high refractive index, preferably of the type ZrO₂/SiO₂/ZrO₂;
- depositing the amorphous external layer containing mostly fluorine and carbon using the ion gun.

7. Method according to claim 6, **characterised in that** each *in vacuo* PVD step includes evaporation by electron bombardment of the material to be deposited.

8. Method according to claim 6 or claim 7, **characterised in that** each deposition step is carried out at a pressure less than or equal to 10⁻² Pa.

9. Use of the method according to any one of claims 1 to 8 to improve the adhesion of a low refractive index exterior layer to the underlying layer of an antireflection stack.

## Patentansprüche

1. Verfahren zur Abscheidung einer hauptsächlich aus Fluor und Kohlenstoff bestehenden amorphen Schicht auf einem Substrat mittels einer Ionenkanone, die Ionen in Form eines Strahls beschleunigter Ionen auswerfen kann, der ausgehend von mindestens einer Zusammensetzung geschaffen wird, die Fluor und Kohlenstoff in gasförmiger Form oder als sättigenden Dampf enthält, der die Ionenkanone versorgt, **dadurch gekennzeichnet, dass** es den Schritt der Abscheidung dieser Schicht als Außenschicht mit niedrigem Brechungskoeffizienten einer Entspiegelungsstapelung, die auf dem Substrat abgeschieden wird, aufweist.

2. Verfahren nach Anspruch 1, **dadurch gekennzeichnet, dass** die Ionenkanone von mindestens einer Vebindung versorgt wird, die Fluor und Kohlenstoff im Gemisch mit Sauerstoff oder mindestens einem Edelgas enthält.

3. Verfahren nach einem der Anspruche 1 und 2, **dadurch gekennzeichnet, dass** die Ionenkanone mit mindestens einer aliphatischen oder zyklische Fluorkohlenstoffverbindung, mindestens einem aliphatischem oder zyklischen Fluorkohlenstoff oder einem Gemisch dieser versorgt wird.

4. Verfahren nach Anspruch 3, **dadurch gekennzeichnet, dass** die Ionenkanone mit Perfluorcyclobutan (c-C₄F₈) oder einem Gemisch dieser Verbindung mit mindestens einer anderen Fluorkohlenetoffverbindung, insbesondere Tetrafluormethan (CF₄) oder Hexafluormethan (C₂F₆) oder mindestens einem Edelgas versorgt wird.

5. Verfahren nach einem der Ansprüche 1 bis 4, **dadurch gekennzeichnet, dass** das Substrat ein Substrat aus Kunststoff ist.

6. Verfahren nach einem der Ansprüche 2 bis 5, **dadurch gekennzeichnet, dass** es darin besteht, eine Entspiegelungsstapelung durch die aufeinander folgenden Schritte herzustellen:
- physikalische Abscheidung in gasförmiger Phase (PVD) unter Vakuum von drei Schichten, die jeweils von innen nach außen einen hohen Brechungskoeffizienten/niedrigen Brechungskoeffizienten/hohen Brechungskoeffizienten haben, vorzugsweise des Typs ZrO₂/SiO₂/ZrO₂;
- Abscheidung der äußeren amorphen Schicht, die hauptsächlich Fluor und Kohlenstoff enthält, mit Hilfe der Ionenkanone.

7. Verfahren nach Anspruch 6, **dadurch gekennzeichnet, dass** jede physikalische Abscheidungsphase in gasförmiger Phase unter Vakuum das Verdampfen des abzuscheidenden Materials durch Elektronenbeschuss aufweist.

8. Verfahren nach Anspruch 6 oder 7, **dadurch gekennzeichnet, dass** jeder Abscheidungsschritt bei einem Druck kleiner oder gleich 10⁻² Pa ausgeführt wird.

9. Einsatz des Verfahrens nach einem der Ansprüche 1 bis 8 zum Verbessern des Haftens einer äußeren Schicht mit niedrigem Brechungskoeffizienten auf der darunter liegenden Schicht einer Entspiegelungsstapelung.
